# EUROPEAN PATENT APPLICATION

(11) **EP 0 840 133 A2**
(43) Date of publication of application: **06.05.1998**
(21) Application number: 97250321.3
(22) Date of filing: 29.10.1997
(51) Int. Cl.: G01R 31/316, G01R 1/073, H01L 21/66, G01R 1/067

(54) **Probe card integrated with dummy components equivalent to parasitic components coupled to bare chip sealed in package**

(30) Priority: 31.10.1996 JP 289407/96
(71) Applicant: NEC CORPORATION, Tokyo (JP)
(72) Inventor: Soejima, Koji, Minato-ku, Tokyo (JP)
(74) Representative: Patentanwälte Wenzel & Kalkoff

(57) **Abstract**

A probe card is connected between an integrated circuit fabricated on a semiconductor wafer (BC) during a diagnostic operation, dummy electric components (26/35) are integrated with conductive probes (34) formed on a ceramic substrate (23), and the dummy electric components are equivalent to parasitic electric components produced when a semiconductor bare chip is sealed in a package (PC), thereby improving reliability of the diagnosis.

## Description

### FIELD OF THE INVENTION

This invention relates to a probe card used in a diagnosis for an integrated circuit device and, more particularly, to a probe card integrated with dummy parasitic components making a semiconductor bare chip equivalent to that sealed in a package.

### DESCRIPTION OF THE RELATED ART

When an integrated circuit is fabricated on a part of a semiconductor wafer, the manufacturer checks the integrated circuit to see whether or not the products are defective. Recently, the test is carried out before separation of the semiconductor wafer into the semiconductor chips, and acceptable semiconductor chips are sealed in packages.

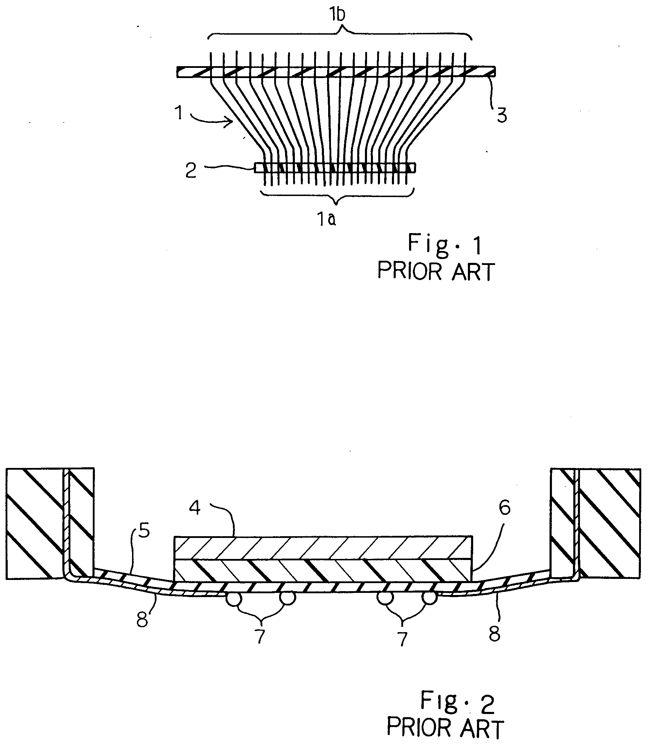

A testing apparatus communicates with the integrated circuit through a probe card, and the probe cards are broken down into two categories. Figure 1 illustrates the first kind of the prior art probe card. The first kind of the prior art probe card is called a "tungsten pin probe card". The prior art tungsten pin probe card includes a plurality of tungsten pins 1. The tungsten pins 1 are arranged in an array, and are electrically isolated from one another. A tungsten pin jig 2 holds the tungsten pins 1 at high density, and contact portions 1a project from the tungsten pin jig 2. The other end portions 1b of the tungsten pins 1 pass through a tungsten pin supporter 3 at low density, and project from the tungsten pin supporter 3. Wiring layers (not shown) are connected to the other end portions 1b and the tungsten pin jig 2 brings the contact portions 1a into contact with electrodes of an integrated circuit device (not shown). When the contact portions 1a are pressed against the electrodes, the tungsten pins 1 are resiliently deformed, and absorb any irregularity of the electrodes.

Figure 2 illustrates the second kind of the prior art probe card called as "membrane probe card". The prior art membrane probe card comprises a supporting board 4. A flexible insulating film 5 such as polyimide is fixed to the supporting board 4 by means of an elastomer layer 6. Conductive bumps 7 are arrayed, and are selectively connected to wiring layers 8 patterned on the flexible insulating film 5. The reverse surface or the upper surface of the flexible film 5 is coated with rubber. The conductive bumps 7 are brought into contact with electrodes of an integrated circuit device (not shown), and a testing apparatus (not shown) communicates with the integrated circuit device through the prior art membrane probe card. The flexible film 5 takes up the irregularity of the electrodes.

However, a problem is encountered in the prior art probe cards in the reliability of tile diagnosis. In other words, the integrated circuit performs differently between the test and an actual operation after installation into an electronic circuit. Especially when the integrated circuit is designed to operate at high frequency, the difference is serious.

### SUMMARY OF THE INVENTION

It is therefore an important object of the present invention to provide a probe card, which improves the reliability of tests.

The present inventor contemplated the problems, and noticed that parasitic inductance, parasitic capacitance and parasitic resistance were coupled to the integrated circuit due to bonding wires and an insulating package. The present inventor tried to mount dummy components equivalent to the parasitic components on the prior art probe cards. However, the dummy components were coupled with difficulty to the prior art probe cards. The tungsten pills were expected to be deformed so as to absorb the irregularity of the electrodes on a semiconductor chip. When the dummy components were attached to the tungsten pins, the dummy components were obstacles against the deformation. For this reason, the dummy components were hardly attached to the prior art tungsten pin probe card. On the other hand, the dummy components were mounted on the upper surface of the flexible film 5. However, the upper surface was coated with rubber, and breakage of the rubber layer deteriorated the flexible film 5. Therefore, it was difficult to connect the dummy components to the wiring layers 8. The present inventor concentrated his efforts on a new probe card, and completed a probe card where probes are integrated with the dummy components.

To accomplish the object, the present invention proposes to integrate a dummy electric component equivalent to a parasitic electric component with conductive probes.

In accordance with one aspect of the present invention, there is provided a probe card used in a diagnostic operation on a bare chip comprising an insulating substrate, a conductive wiring structure formed in the insulating substrate, a plurality of conductive probes supported by the insulating substrate and electrically connected to the conductive wiring structure and at least one dummy electric component supported by the insulating substrate, electrically connected to the conductive wiring structure and equivalent to a parasitic electric component produced when the bare chip is sealed in a package.

### BRIEF DESCRIPTION OF THE DRAWINGS

The features and advantages of the probe card will be more clearly understood from the following description taken in conjunction with the accompanying drawings in which:
Fig. 1 is a cross sectional view showing the structure of the prior art tungsten pin probe card;
Fig. 2 is a cross sectional view showing the structure of the prior art membrane probe card;
Figs. 3A to 3E are perspective views showing a process sequence for fabricating a probe card according to the present invention;
Figs. 4A and 4B are plan views showing the arrangement in a part of a ceramic structure at essential steps of the process sequence;
Figs. 5A and 5B are cross sectional views taken along line A-A of figure 4A and showing the structure of the ceramic structure at essential steps of the process;
Fig. 5C is a cross sectional view taken along line B-B of Fig. 4B;
Fig. 6A is a graph showing the waveform of a signal supplied through the probe card to a semiconductor bare chip;
Fig. 6B is a graph showing the waveform of a signal supplied through the prior art tungsten pin probe card to a semiconductor bare chip;
Fig. 7 is a cross sectional view showing the structure of another probe card according to the present invention;

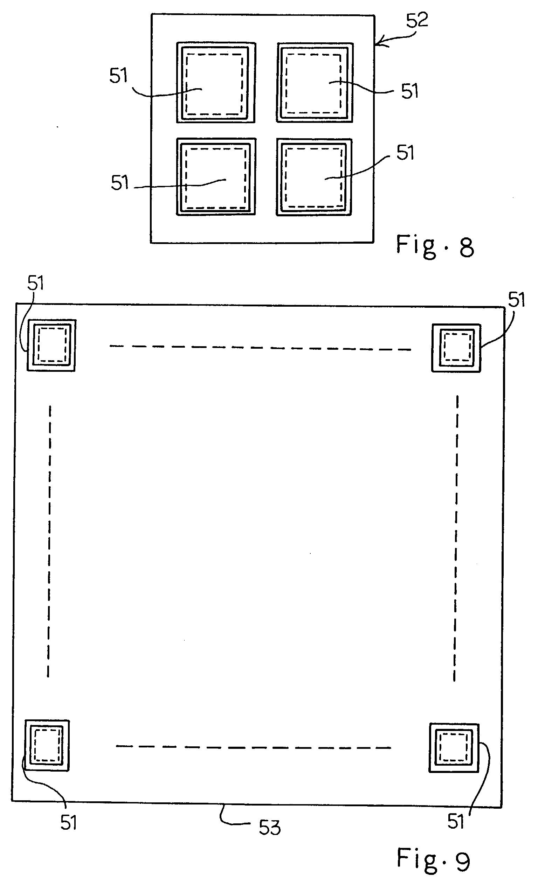

Fig. 8 is a plan view showing a layout of probe arrays;
Fig. 9 is a plan view showing another layout of probe arrays;
Figs. 10A and 10B are plan views showing another process sequence for fabricating a probe card according to the present invention; and
Figs. 11A to 11C are cross sectional views showing the probe card at essential steps during the process sequence.

### DESCRIPTION OF THE PREFERRED EMBODIMENTS

### First Embodiment

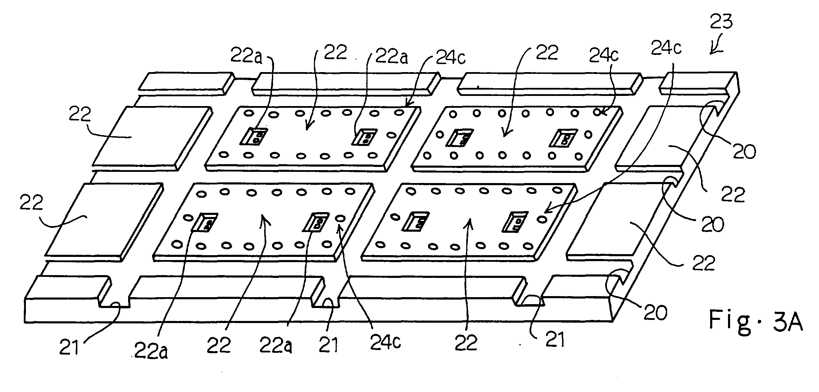

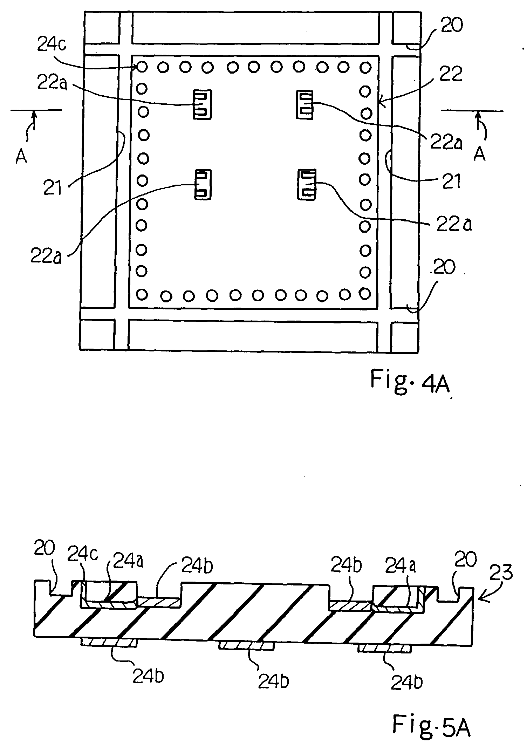

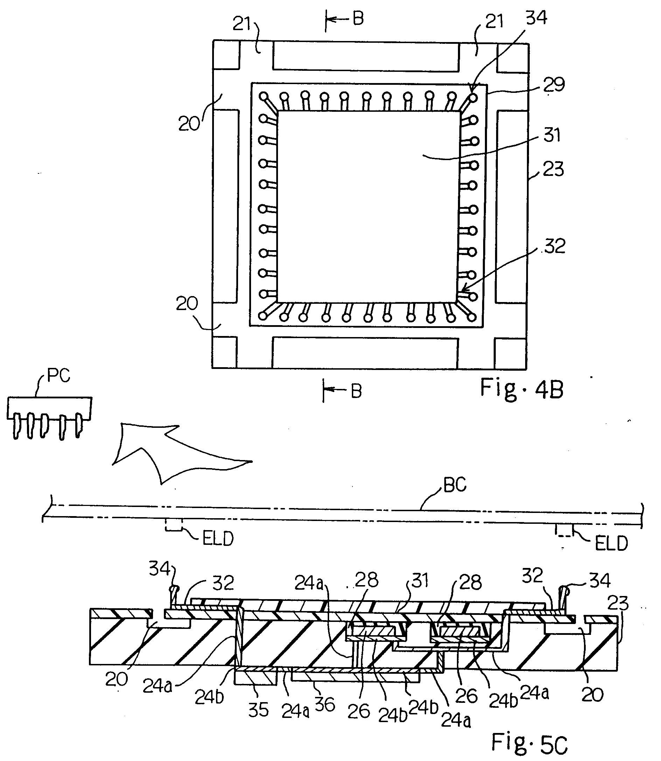

Referring first to figure 3A to 3E, figures 4A and 4B and figures 5A to 5C, a process sequence embodying the present invention starts with preparation of ceramic green sheets. Conductive paste is screen printed on the ceramic green sheets. The ceramic green sheets are laminated, and longitudinal moats 20 and lateral moats 21 are formed in the laminated structure. The longitudinal moats 20 and the lateral moats 21 extend like a lattice, and define a plurality of rectangular islands 22, one of which is shown in figure 4A. Cavities 22a are formed in the island 22, and parts of the conductive paste patterns are exposed to the cavities 22a. The conductive paste pattern is further exposed to the surface of the islands 22.

The laminated structure is sintered, and the ceramic green sheets and the conductive paste patterns are formed into a ceramic body 23 and conductive wiring layers/electrodes 24a/24b, respectively. The conductive wiring layers 24a are terminated at certain areas of the surface of each island 22, and form a conductive dot pattern 24c.

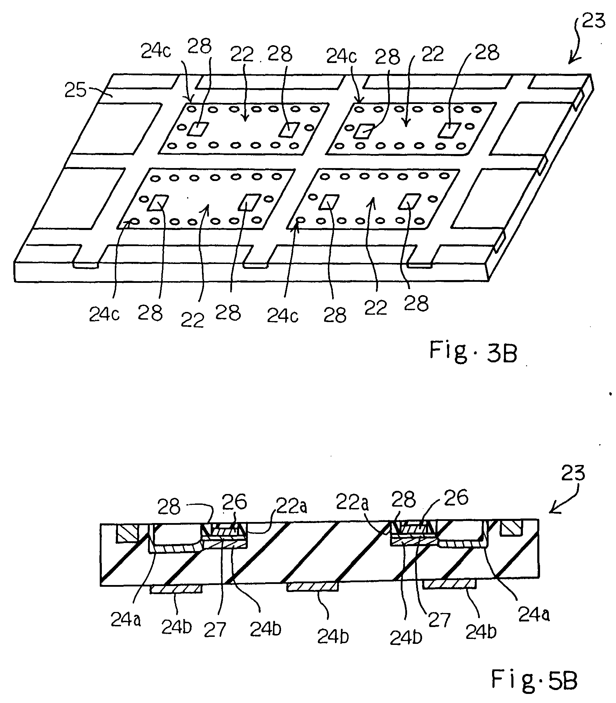

The process proceeds to the next step illustrated in figures 3B and 5B. Silver paste fills the longitudinal grooves 20 and the lateral grooves 21, and is fired at 400 degrees in centigrade. Then, a silver lattice 25 is formed in the longitudinal moats 20 and the lateral moats 21. Silver powder is mixed with an organic vehicle so as to produce silver paste, and the electrodes 24b in the cavities 22a and the bottom surfaces of the cavities 22a around the electrodes 24b are covered with silver paste layers, respectively. Small discrete electric components 26 are put on the silver paste layers, respectively, and glass paste fills the cavities 22a. The silver paste and the glass paste are fired at 250 degrees centigrade, and are solidified to be silver layers 27 and glass layers 28. The silver layers 27 connect the small discrete electric components 26 to the electrodes 24b, and the glass layers 28 seal the small discrete electric components 26 into the cavities 22a. The upper surface of the resultant structure is polished so as to make the ceramic body 23, the silver lattice 25 and the glass layers 28 coplanar.

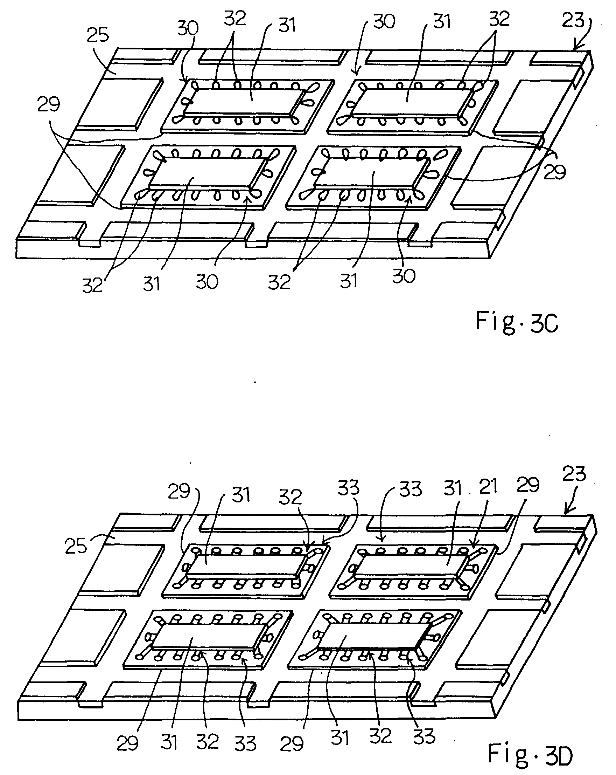

The process proceeds to the next step shown in figure 3C. Precursor of polyimide is spun onto the polished surface, and the polyimide layer is patterned through lithographic techniques . The periphery of each of the polyimide layers 29 is on the silver lattice 25. Then, through-holes are formed in the polyimide layers 29, and the conductive dot patterns 24c are exposed to the through-holes in the polyimide layers 29. Chromium is deposited to 0.1 micron thick over the resultant structure by using sputtering, and palladium is further deposited to 0.1 micron thick over to the chromium layer. Thus, the polyimide layers 29 are overlain by a composite conductive layer of chromium/palladium, and the composite conductive layer is patterned into conductive wiring layers 30 on the polyimide layers 29. The conductive wiring layers 30 pass through the through-holes to the dot patterns 24c. In this instance, conductive metal is further plated on the conductive wiring layers 30 by using an electroplating. Polyimide is further spread over the resultant structure, and the polyimide layer is patterned into polyimide strips 31 by using lithography. The conductive wiring layers 30 are covered with the polyimide strips 31, and partially uncovered therewith. The leading end portions of the conductive wiring layers 30 serve as electrodes 32, and the electrodes 32 are on the peripheries of the polyimide layers 29.

The process proceeds to the next step shown in figure 3D. Conductive ball bumps 33 are bonded to the electrodes 32, and are 40 microns in height. Rhodium is deposited to 1 micron thick on the surfaces of the conductive ball bumps 33 by using an electroplating. The conductive ball bumps 33 covered with the rhodium films serve as probes 34.

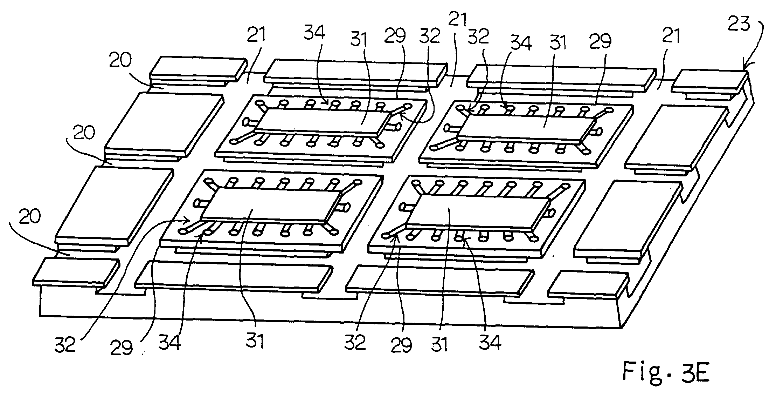

The process proceeds to the next step shown in figures 3E, 4B and 5C. The silver lattice 25 is etched away, and the longitudinal moats 20 and the bottom surfaces of the longitudinal/lateral moats 20/21 are exposed, again. The peripheries of the polyimide layers 29 project from the ceramic body 23, and the probes 33 are over the longitudinal/lateral moats 20/21. In other words, the probes 33 are supported by the peripheries of the polyimide layers 29 in a cantilever fashion. For this reason, when electrodes ELD of a semi-conductor bare chip BC or a part of a semiconductor wafer is pressed against the probes 34, the peripheries of the polyimide layers 29 are bent, and absorb irregularity of height of the electrodes ELD. Discrete capacitor chips 35 and a semiconductor integrated circuit device 36 used in testing operations are fixed to the electrodes 24b formed on the reverse surface of the ceramic body 23. Though not shown in figure 5C, a discrete inductor is also provided on another electrode 24b on the reverse surface of the ceramic body 23. Thus, the probe card according to the present invention is completed.

In this instance, the conductive wiring layers 24a and electrode 32 connect the small discrete circuit component 26 to the probe 34, and the electric path between the small discrete circuit component 26 and the probe 34 closest to the component 26 is of the order of 1 millimeter long. Tie electric path between the discrete capacitor chip 35 and the electrode 32 is about 6 millimeters long, and the semiconductor integrated circuit device 36 is connected to the probe 34 through an electric path of 10 millimeters in length. The discrete capacitor chip 35 is 0.01 microfarad. The conductive wiring layers 24a, the discrete capacitor chips 35 and the discrete inductors serve as dummy components, and couple a parasitic impedance to a semiconductor bare chip. For this reason, the manufacturer check the semiconductor bare chip BC as if the chip BC has been already sealed in a package PC.

The present inventor evaluated the probe card according to the present invention. The present inventor prepared the probe cards shown in figure 5C and the prior art tungsten pin probe card. One of the probe cards, i.e., the first probe card according to the present invention had the electric paths described hereinbefore, and the other probe card, i.e., the second probe card was different in electric paths from the probe card described hereinbefore. The electric path between the probe 34 and the discrete circuit component closest thereto was 5 millimeters long, and the electric path between the probe 34 and the other discrete circuit component was 10 millimeters long. Although the capacitor chip 35 was also 0.01 microfarad, the electric path between the semiconductor integrated circuit device 36 and the probe 34 was increased to 20 millimeters long. The dummy components formed an impedance matching circuit, and the input signal impedance matching had been carried out. A power generator had small impedance, and the terminal was matched with the characteristic impedance.

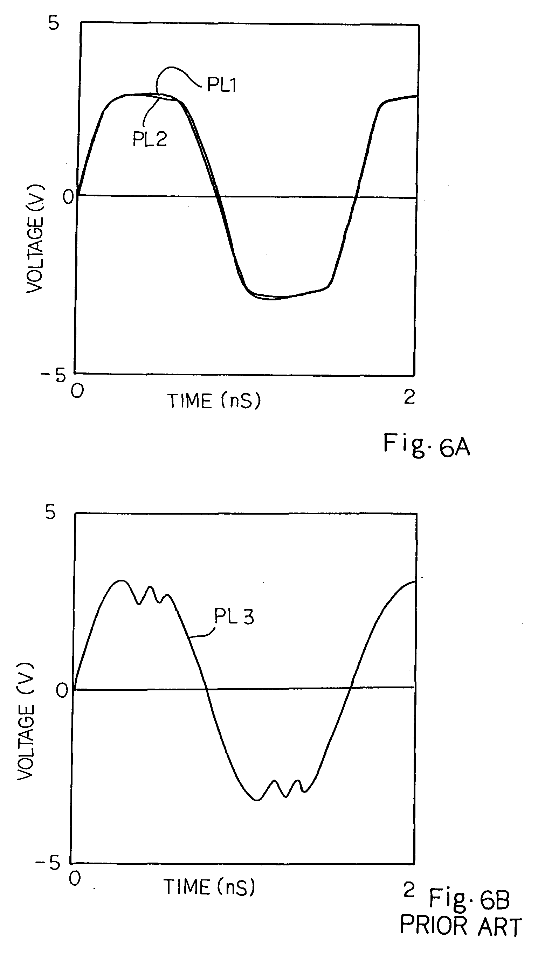

The present inventor connected the probe card according to the present invention and the prior art tungsten pin probe card to the electrodes of a bare chip, and measured the waveform of the signal. The first and second probe cards according to the present invention did not seriously deform the waveform as indicated by plots PL1 and PL2 in figure 6A. On the other hand,the prior art tungsten pin probe card was causative of distortion of the waveform as indicated by plots PL3 in figure 6B. Comparing plots PL1 with plots PL2, it was understood that the length of the electric path affected the waveform, because the plots PL2 was slightly deformed.

### Second Embodiment

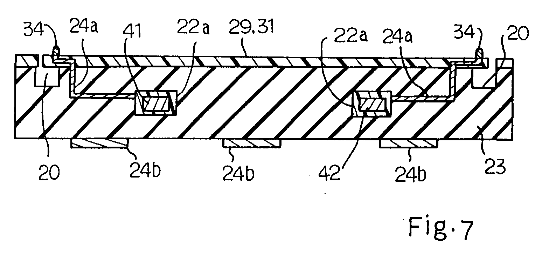

Figure 7 illustrates another probe card embodying the present invention. The probe card implementing the second embodiment is similar to the first embodiment except for accommodation of dummy circuit components 41/42. In this instance, all of the dummy circuit components 41/42 are sealed in the cavities 22a, and the electric paths are shortened rather than those of the first embodiment. The members of the second embodiment are labeled with references designating corresponding to those of the members of the first embodiment without detailed description.

The present inventor confirmed that the probe card implementing the second embodiment achieved the advantages of the first embodiment, and the short electric paths further improved the waveform of the signal.

In the first and second embodiments, four probe arrays 51 may be arranged on a probe card 52. The probe array 51 corresponds to the probes 34 formed on each polyimide layer 29. Each probe array 51 is used for communication with a semiconductor bare chip , and the probe card 52 is used for a diagnosis of four semiconductor bare chips. If the probe arrays 51 are arranged in eight columns by eight rows on a probe card 53, sixty-four semi-conductor bare chips are concurrently tested through the probe card 53.

### Third embodiment

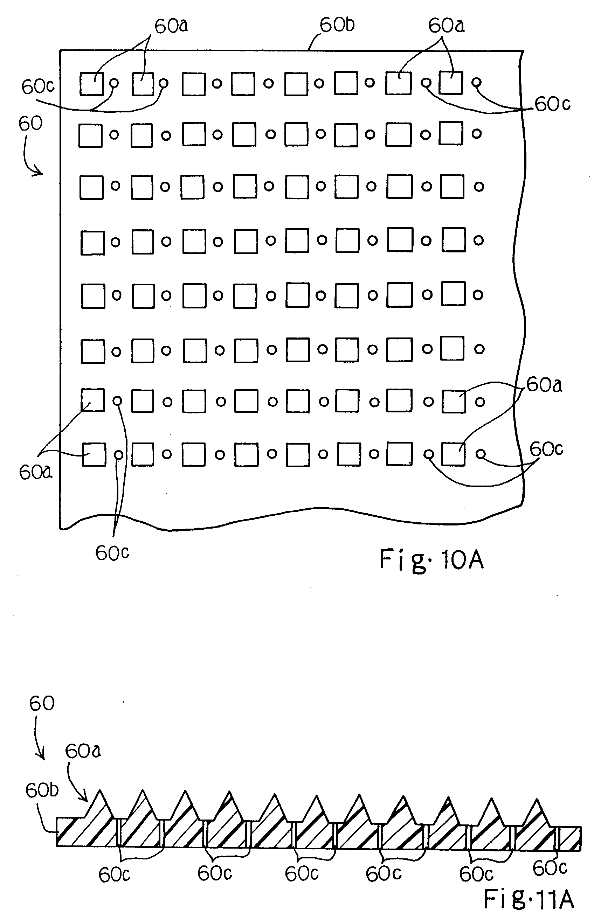

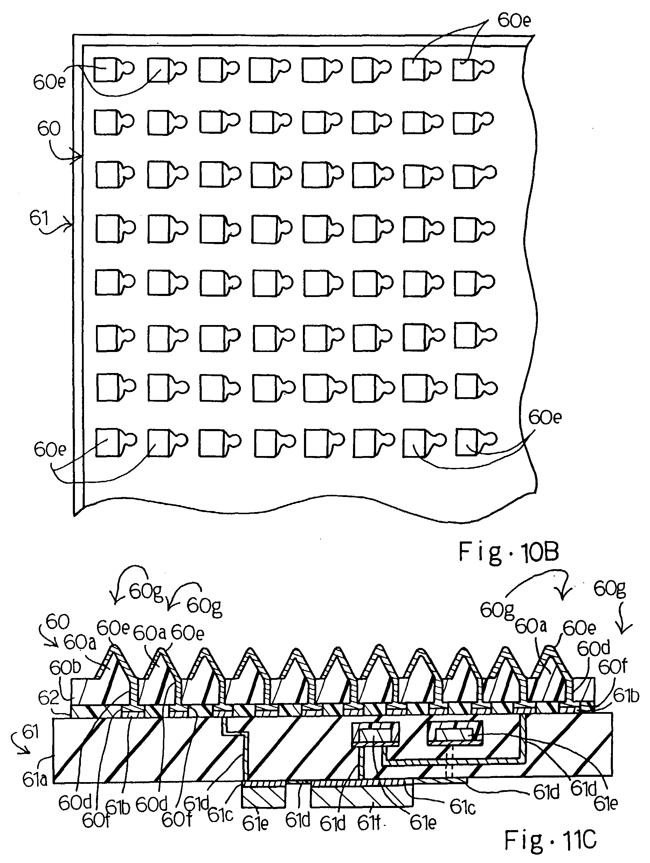

Yet another process for fabricating a probe card embodying the present invention starts with preparation of a probe substrate 60 (see figures 10A and 11A) and a multi-layer wiring structure 61 (see figures 10B and 11C). ABS (Acrylonitrile Butadien Styrene) resin is molded into the probe substrate 60. The probe substrate 60 includes small pyramids 60a of 100 microns high arrayed at pitch of 300 microns on a base portion 60b as shown in figure 10A, and through-holes 60c are accompanied with the small pyramids 60a, respectively. The through-holes 60c are open to upper and lower surfaces of the base portion 60b as shown in figure 11A.

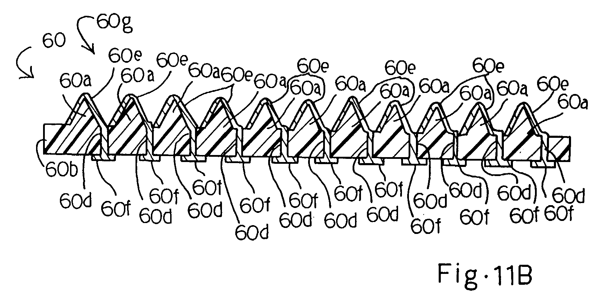

The process proceeds to the next step shown in figure 11B. Using an additive technique, the through-holes 60c are clogged with conductive plugs 60d, and the small pyramids 60a are covered with conductive films 60e. The electrodes 60f are formed on the lower surface of the base portion 60b, and the conductive plugs 60f connect the conductive films 60e to the electrodes 60f. In detail, the probe substrate 60 is dipped in photo-resist solution, and a pattern image is transferred to the photo-resist layer so as to form a latent image therein. The latent image is developed, and a photo-resist mask is provided on the probe substrate 60. The small pyramids 60a and areas around the through-holes 60c are exposed to openings of the photo resist mask. Conductive material is deposited on the small pyramids 60a and the exposed areas around the through-holes 60c by using an electroless plating technique. The small pyramids 60a covered with the conductive films 60e serve as probes 60g, and the probes 60g are electrically connected through the conductive plugs 60d to the electrodes 60f, respectively.

The multi-layer wiring structure 61 is similar to that of the first embodiment, and includes a ceramic body 61a, upper electrodes 61b formed on the upper surface of the ceramic body 61a, lower electrodes 61c formed on the lower surface of the ceramic body 61b, conductive wiring layers 61d formed in and on the ceramic body 61a, dummy electric components 61e electrically connected to the electrodes 61b/61c and a semiconductor integrated circuit device 61f bonded to one of the lower electrodes 61d. The dummy electric components 61e are selectively sealed in cavities and bonded to the lower electrodes 61c. An inductor, a resistor and a capacitor selectively serve as the dummy electric components 61e, and the dummy electric components 61e are electrically connected through the conductive wiring layers 61d to the upper electrodes 61b. The semiconductor integrated circuit device 61f assists a testing apparatus (not shown) in a diagnostic operation.

The process proceeds to the next step shown in figures 10B and 11C. The electrodes 60f are laminated on the upper electrodes 61b, and anisotropic conductive resin 62 fills the gap between the probe substrate 60 and the multi-layer wiring structure 61. The anisotropic conductive resin 62 is, by way of example, implemented by epoxy resin containing conductive powder, and provides electric isolation in the lateral direction. For this reason, the electrodes 60f are never short circuited. The dummy electric components 61e are coupled to the conductive probes 60g, and make a semiconductor bare chip (not shown) as if the chip is sealed in a package. In this instance , the shortest electric path between the probe 60g and the dummy electric components 61e is of the order of 2 millimeters long.

The present inventor evaluated the probe card implementing the third embodiment, and confirmed that the characteristics of the probe card was close to that shown in figure 6A.

As will be appreciated from the foregoing description, the dummy electric components are integrated with the conductive probes, and are equivalent to parasitic electric components produced when a semiconductor bare chip is sealed in a package. Using the probe card according to the present invention, the manufacturer diagnoses semiconductor bare chips as if the bare chips are sealed in packages, and the diagnosis is highly reliable. Moreover, in cases where the semiconductor bare chip is a microwave device, the dummy electric components are expected to be as close to the semiconductor bare chip as possible. This is because of the fact that an electric component spaced from the semiconductor bare chip by a single waveform is not affective. Thus, the probe card according to the present invention is desirable for the micro-wave devices.

Although particular embodiments of the present invention have been shown and described, it will be obvious to those skilled in the art that various changes and modifications may be made without departing from the spirit and scope of the present invention.

For example, the probes may be implemented by silicon whiskers covered with conductive material.

All of the dummy electric components may be fixed to the electrodes formed on the reverse surface of the ceramic body.

## Claims

1. A probe card used in a diagnostic operation on a bare clip (BC) comprising
an insulating substrate (23; 61a),
a conductive wiring structure (32/24a/24b; 61d) formed in said insulating substrate, and
a plurality of conductive probes (34; 60g) supported by said insulating substrate and electrically connected to said conductive wiring structure,
characterized by
at least one dummy electric component (26/35; 61e) supported by said insulating substrate, electrically connected to said conductive wiring structure and equivalent to a parasitic electric component produced when said bare chip is sealed in a package (PC).

2. The probe card as set forth in claim 1, in which said insulating substrate has a cavity (22a) for accommodating said at least one dummy electric component.

3. The probe card as set forth in claim 2, further comprising another dummy electric component (35/26; 61e), and the combination of said at least one dummy electric component and said another electric component is equivalent to said parasitic electric component.

4. The probe card as set forth in claim 3, in which said another dummy electric component is accommodated in another cavity (22a) formed in said insulating substrate.

5. The probe card as set forth in claim 3, in which said another dummy electric component is fixed to an electrode (24b; 61c) formed on a surface of said insulating substrate.

6. The probe card as set forth in claim 5, in which said plurality of conductive probes (34; 60g) are provided over another surface reverse to said surface where said electrode (24b; 61c) is formed.

7. The probe card as set forth in claim 1, in which said at least one dummy electric component (35; 61e) is fixed to an electrode (24b; 61c) formed on a surface of said insulating substrate.

8. The probe card as set forth in claim 1, in which said plurality of conductive probes (34) are provided on a resilient organic layer (29) supported by said insulating substrate (23) in a cantilever fashion.

9. The probe card as set forth in claim 8, in which said insulating substrate (23) has a moat (20/21) open to a surface thereof, said resilient organic layer (29) is formed on said surface in such a manner as to project an peripheral portion over said moat, and said plurality of conductive probes (34) are mounted on said peripheral portion.

10. The probe card as set forth in claim 1, further comprising a semiconductor integrated circuit device (36; 61f) fixed to an electrode (24b; 61c) formed on a surface of said insulating substrate and electrically connected to said conductive wiring structure for assisting a testing apparatus in a diagnostic operation on said bare chip.

11. The probe card as set forth in claim 1, in which a plurality of protrusions (60a) of organic compound projecting from a surface of a base portion(60b) of said organic compound, a plurality of conductive films (60e) respectively covering said plurality of protrusions, a plurality of electrodes (60f) formed on another surface of said base portion and a plurality of conductive plugs (60d) filling through-holes formed in said base portion for connecting said plurality of conductive films to said plurality of electrodes constitute said plurality of conductive probes.

12. The probe card as set forth in claim 1, in which said bare chip (BC) forms a part of a semiconductor wafer together with other bare chips.
